# FASCICULE DE BREVET EUROPEEN

(11) **EP 3 928 599 B1**
(45) Date de publication et mention de la délivrance du brevet: **21.12.2022**
(21) Numéro de dépôt: 20704919.8
(22) Date de dépôt: 20.02.2020
(51) Int. Cl.: H05K 3/34, B23K 1/20, H01L 23/00, B23K 1/00, B23K 1/012, B23K 26/362, B23K 101/42

(54) **PROCÉDÉ D'ASSEMBLAGE DE COMPOSANTS METTANT EN OEUVRE UN PRÉTRAITEMENT DES BOSSAGES DE BRASURE PERMETTANT UN ASSEMBLAGE PAR BRASAGE SANS FLUX ET SANS RÉSIDU**
ZUSAMMENBAUVERFAHREN VON BAUTEILEN MIT INBETRIEBNAHME EINER VORBEHANDLUNG VON LÖTHÖCKER, DIE EIN LÖTFLUSSMITTELLOSES ZUSAMMENBAUVERFAHREN OHNE RESTSTOFFE ERMÖGLICHT
ASSEMBLY PROCESS OF COMPONENTS IMPLEMENTING A PRETREATMENT OF SOLDER BUMPS ALLOWING A FLUXLESS ASSEMBLY PROCESS WITHOUT RESIDUES

(30) Priorité: 20.02.2019 FR 1901695
(43) Date de publication de la demande: 29.12.2021
(73) Titulaire: Commissariat à l'Energie Atomique et aux Energies Alternatives, 75015 Paris (FR)
(72) Inventeur: CASTANY, Olivier, 38054 GRENOBLE CEDEX 9 (FR); CAICEDO PANQUEVA, Nohora-Lizeth, 38054 GRENOBLE CEDEX 9 (FR); MILOUD-ALI, Nadia, 38054 GRENOBLE CEDEX 9 (FR); ZONOU, Yezouma-dieudonné, 38054 GRENOBLE CEDEX 9 (FR)
(74) Mandataire: Hautier IP
(86) Numéro de dépôt international: PCT/EP2020/054503
(87) Numéro de publication internationale: WO 2020/169743

(56) Documents cités:
- EP-A1- 0 884 936
- DE-A1- 3 144 157
- US-A- 5 865 365

## Description

### DOMAINE TECHNIQUE

La présente invention concerne le domaine de l'assemblage de dispositifs électroniques et plus particulièrement le domaine de la microélectronique, cet assemblage permettant un raccordement électrique et mécanique de composants. L'invention trouve pour application avantageuse, mais non limitative, la fabrication de dispositifs microélectroniques. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS, écrans matriciels, puces laser...).

### ÉTAT DE LA TECHNIQUE

Les systèmes microélectroniques sont de complexité croissante ce qui implique un nombre croissant d'interconnexions électriques entre les composants. Il est connu de reporter des composants sur d'autres composants par le biais de « bossages de brasure » (« solder bumps » en anglais) servant de connecteurs à la fois pour la liaison mécanique et la continuité électrique, et permettant d'atteindre une forte densité de connexions.

Un bossage (« bump en anglais ») est une protrusion qui dépasse à la surface d'un composant. Une brasure (« solder » en anglais) est un matériau apte au brasage, par exemple de l'étain ou de l'indium. Le brasage (« soldering » en anglais) est une opération qui permet de lier deux objets par un joint de brasure. Elle comporte une première étape de montée en température lors de laquelle la brasure fond et mouille les deux objets à connecter, puis une étape de descente en température lors de laquelle le matériau se solidifie, laissant un joint de brasure solide qui lie les deux objets entre eux. Les bossages de brasure sont par exemple des billes de brasure (typiquement de l'étain ou de l'indium) préparées sur des plots métalliques à la surface du composant. Dans une autre configuration, ces bossages de brasure comportent une base en cuivre nommée « pilier de cuivre » (« copper pillar » en anglais) surmontée d'un matériau de brasure (typiquement de l'étain). Pour des tailles de bossage inférieures à 50 µm, on peut utiliser le terme de micro-bossage (« micro-bumps » en anglais).

Un premier composant présentant des bossages de brasure est destiné à être connecté à un deuxième composant présentant des « connecteurs » sur sa surface. Le terme « connecteur » s'entend de tout organe ayant une fonction de raccordement électrique et/ou une fonction de raccordement mécanique, de sorte que le raccordement de deux connecteurs produise une fonction de conduction électrique au travers des deux connecteurs assemblés et/ou une fonction de solidarisation mécanique permettant de relier de manière immobile les deux composants. Lorsque les deux composants sont mis en regard lors du procédé d'assemblage, les bossages de brasure du premier composant se retrouvent en face des connecteurs du deuxième composant, en vue d'être connectés l'un à l'autre par un joint de brasure. Les connecteurs du deuxième composant sont par exemple des plots métalliques. La constitution et la structure de ces plots métalliques sont typiquement choisies pour trois aspects : favoriser un bon mouillage de la brasure liquide sur la surface des plots lors de la phase de brasage à haute température ; limiter la diffusion des matériaux lors de la phase à haute température et pendant toute la vie ultérieure du produit ; permettre une bonne accroche de la brasure à l'état solide sur le plot métallique. Un exemple de métallisation communément utilisée est la structure en trois couches Ti (200 nm) / Ni (700 nm) /Au (100 nm). La situation ainsi décrite est un assemblage de « bossages sur plots » où l'on a envisagé que le premier composant possède des bossages et le deuxième possède des plot métalliques. Toutefois, la notion de premier et deuxième composant est arbitraire, de sorte que la situation inverse peut être envisagée de façon équivalente. Dans une variante, les connecteurs du deuxième composant sont aussi des bossages de brasure, ce qui correspond à un assemblage de « bossages sur bossages ».

Lors du procédé d'assemblage, les deux composants sont mis en vis-à-vis de sorte que les connecteurs des composants soient en regard, puis les composants sont rapprochés jusqu'au contact des connecteurs. Ensuite l'ensemble est chauffé pour que le matériau de brasure fonde et établisse un joint entre les deux connecteurs, puis se solidifie lors du retour à température ambiante. Cette méthode permet autant un assemblage unitaire de composants qu'un assemblage collectif de composants. Un assemblage unitaire consiste en l'assemblage d'un seul composant sur un seul autre composant. Un assemblage collectif consiste en l'assemblage d'une pluralité de composants sur une autre pluralité de composants avec un seul cycle thermique pour l'ensemble. Dans ce cas, l'autre pluralité de composants peut être un ensemble de composants disposés sur le plateau de travail de l'équipement d'assemblage, ou bien un wafer entier posé sur le plateau de l'équipement d'assemblage (les composants pourront être individualisé par la suite en découpant le wafer), ou bien encore un ensemble de composants disposés sur une plaque indépendante (qui pourra être retirée de l'équipement d'assemblage, ce qui permet de transporter l'ensemble des composants en une fois).

Pour réaliser l'assemblage avec succès, un détail essentiel à considérer est le traitement à appliquer aux bossages de brasure. En effet, la brasure des bossages se recouvre progressivement d'une couche d'oxyde lorsque les composants sont au contact d'une atmosphère contenant de l'oxygène, ce qui rend l'assemblage impossible après quelques jours de stockage dans l'air. La méthode de traitement la plus couramment utilisée est de déposer un « flux liquide » (« solder flux » en anglais) sur les composants, puis d'effectuer le cycle thermique d'assemblage et de fusion de la brasure en présence de ce flux liquide. Il est connu que le rôle du flux liquide est de désoxyder la surface de la brasure (par exemple en retirant la fine couche d'oxyde d'étain si c'est une brasure à base d'étain) et de protéger la brasure de l'action néfaste de l'oxygène lors de l'opération à température élevée (effet de couverture), ces deux effets permettant une connexion correcte des connecteurs. En l'absence de flux, les connexions mécaniques et électriques sont de mauvaise qualité, peu fiables, ou ne se font pas du tout (c'est-à-dire que les composants ne sont pas attachés mécaniquement après l'opération). Malheureusement l'utilisation de flux liquide laisse toujours des résidus, qui pénalisent la fiabilité des connexions sur le long terme (dégradation progressive de la connexion à cause de l'action chimique des résidus), ou pénalisent la transmission de lumière entre deux composants (par obstructions des faisceaux) dans le cas où les composants ont une fonction optique (imageurs ou puces photoniques), ou rendent aléatoire l'infiltration de colle dans l'interstice entres les deux composants. Ce dernier point est important car les assemblages sont en général renforcés par un collage des deux composants. Une colle est par exemple infiltrée par capillarité dans l'interstice entre les deux composants assemblés, puis est polymérisée thermiquement. Le but est de renforcer l'assemblage au niveau mécanique pour sa solidité, mais aussi de protéger les connecteurs de l'atmosphère extérieure, en particulier de l'oxygène et de la vapeur d'eau qui ont un effet néfaste à long terme s'ils sont directement au contact des connecteurs. La colle polymérisée entre les deux composants est nommée « underfill » en anglais. Le problème des résidus de flux est qu'ils empêchent la colle de s'infiltrer de manière répétable et homogène, et créent des manques de colle ou piègent des bulles d'air, ce qui est une source de fragilité pour l'assemblage réalisé et sa fiabilité à long terme. Les flux qualifiés de « sans nettoyage » (« no clean » en anglais) sont avantageux car les résidus qu'ils laissent ne dégradent pas les connexions dans le long terme, et dans ce sens, il n'est pas nécessaire de les nettoyer. Toutefois, les résidus qu'ils laissent sont visibles, ils nuisent aux applications optiques et gênent l'infiltration d'un underfill.

Pour éviter ces problèmes, il est nécessaire de nettoyer les résidus de flux, ce qui est habituellement fait à l'aide de solvants après l'assemblage et avant l'application de l'underfill. Malheureusement, la densification et la réduction de la taille des bossages s'accompagne d'une réduction de l'espace entre les faces des deux composants assemblés, ce qui complique le retrait de résidus de flux car il devient impossible pour le liquide de nettoyage de pénétrer efficacement dans l'interstice étroit entre les composants.

On a donc alternativement parfois recours à des flux gazeux, correspondant à la technique dite « sans flux » (« fluxless » en anglais) qu'il faut comprendre comme signifiant « sans flux liquide ». Ces flux gazeux ont l'avantage de ne pas laisser de résidu. Les gaz employés sont des gaz réducteurs, comme par exemple l'acide formique (HCOOH) ou le « forming gaz » (H₂ dilué dans N₂). Il faut noter que ces gaz sont inflammables et/ou toxiques si bien qu'un environnement de travail spécial est requis, ce qui est un inconvénient au niveau pratique et au niveau de la sécurité. De plus l'expérience montre que leur effet n'est pas toujours avéré et fiable, notamment dans le cas des brasures à base d'étain.

Alternativement, il est possible d'effectuer un prétraitement des bossages de brasure avant l'assemblage et de réaliser ensuite l'assemblage sans flux liquide ou gazeux. Les prétraitements connus utilisent des gaz ou des plasmas dans le but de désoxyder la surface de la brasure des bossages préalablement à l'assemblage (par exemple en utilisant un plasma de SF₆). Malheureusement ces techniques ne s'avèrent pas suffisamment fiables car l'expérience montre que le rendement d'assemblage est faible. Des plus elles nécessitent des enceintes de traitement spécialisées dont la mise en œuvre est coûteuse.

Une alternative supplémentaire exposée dans le brevet US5865365 et dans la demande de brevet EP0884936A1 consiste à recouvrir les bossages de brasure avec un liquide à haut point d'ébullition, qui agit comme une couverture lors du cycle thermique en protégeant la brasure de l'action néfaste de l'oxygène. Le liquide est choisi avec une température d'ébullition supérieure à la température de fusion de la brasure, mais inférieure à la température maximale du procédé, de sorte qu'il se vaporise au cours du cycle thermique sans laisser de résidu. Il est expliqué que ce liquide est avantageusement un alcool pour permettre, en plus de l'effet de couverture, de réduire la couche d'oxyde présente sur la brasure. Un inconvénient du procédé est que ce liquide, pour couvrir les bossages et assurer sa fonction, doit remplir une grande partie de l'interstice entre les composants à assembler, ce qui représente un volume important à l'échelle de l'assemblage et peut causer un déplacement relatif des composants à cause des bulles qui se créent lors de l'ébullition du liquide. Un autre inconvénient est que l'ensemble du liquide doit se vaporiser sans laisser de résidu alors qu'il est confiné entre les faces des composants assemblés, ce qui lui laisse peu de passage pour s'échapper. Il peut donc être nécessaire d'allonger le temps de cycle pour laisser au liquide le temps de se vaporiser en totalité, voire même de favoriser sa vaporisation en plaçant les assemblages dans une atmosphère à pression réduite.

C'est donc un objet de l'invention que de pallier au moins en partie les inconvénients des techniques actuelles.

### RÉSUMÉ

Un but de la présente invention est de proposer un procédé d'assemblage par bossages de brasure, permettant d'assembler un premier composant comportant des bossages de brasure avec un second composant comportant des connecteurs, l'assemblage des composants est précédé d'un prétraitement des composants lors duquel les bossages de brasure sont mis en contact avec un liquide de prétraitement configuré pour retirer au moins en partie la couche d'oxyde initialement présente sur la brasure, et l'assemblage des composants est réalisé ensuite en l'absence de flux liquide ou gazeux, et éventuellement sous atmosphère de gaz neutre tel que de l'azote, caractérisé en ce que le liquide de prétraitement est une solution aqueuse contenant des acides carboxyliques ou des polyacides carboxyliques. Le prétraitement permet un assemblage efficace malgré l'absence de flux, et sans résidu.

Lors de l'opération d'assemblage, les deux composants sont mis en regard de sorte que les bossages de brasure du premier composant se retrouvent au contact des connecteurs du second composant pour former des joints de brasure. Le procédé comporte les étapes suivantes :
Un prétraitement lors duquel les composants portant des bossages de brasure sont mis au contact d'un liquide de prétraitement permettant simultanément de retirer la couche d'oxyde et la contamination organique qui sont initialement présentes sur la brasure des bossages, et de rendre possible leur brasage ultérieur sans utiliser de flux.

Une mise en contact des composants, sans utilisation de flux liquide ou gazeux, lors de laquelle les bossages de brasure du premier composant rencontrent les connecteurs du deuxième composant.

Une montée en température causant la fusion de la brasure des bossages et le mouillage de la brasure liquide sur les connecteurs en regard.

Une baisse de la température permettant la solidification des joints de brasure, de sorte que chaque bossage de brasure du premier composant soit lié par un joint de brasure solide au connecteur lui faisant face sur le second composant.

Selon un mode de mise en œuvre, le liquide de prétraitement est une solution contenant un détergent basique, le pH de ladite solution étant de préférence compris entre 11 et 13.

Selon un mode de mise en œuvre, le liquide de prétraitement est une solution contenant un détergent acide, le pH de ladite solution étant de préférence compris entre 1 et 3.

Selon un mode de mise en œuvre, le détergent est de préférence non moussant, le contact avec le liquide de prétraitement peut être fait par immersion et par exemple dans un bain à ultrasons, le temps de contact avec le liquide de prétraitement est de préférence compris entre 1 et 5 minutes, le contact avec le liquide de prétraitement est suivi d'un rinçage, fait par exemple avec de l'eau ou de l'isopropanol, puis d'un séchage, l'assemblage par brasage étant ensuite réalisé de préférence moins d'une heure après le prétraitement et de préférence sous une atmosphère de gaz neutre.

Selon un mode de mise en œuvre, le liquide de prétraitement est configuré pour laisser un film mince sur la surface des composants traités, d'une épaisseur de préférence inférieure à 100 nm, ce film ayant la propriété de favoriser un brasage efficace sans pour autant laisser de résidus après assemblage, et de permettre de prolonger l'action du prétraitement de sorte que le brasage puisse être fait plus d'une heure après le prétraitement sans diminution du rendement d'assemblage.

Selon un mode de mise en œuvre, le liquide de prétraitement peut avantageusement contenir des amines ou des diamines ou plus généralement des polyamines, et peut de manière encore plus avantageuse contenir des acides aminés ou des diacides aminés ou plus généralement des polyacides aminés, qui combinent les fonctions acide carboxylique et amine.

Selon un mode de mise en œuvre, le liquide de prétraitement est une solution aqueuse contenant du chlorhydrate d'acide glutamique, dans une concentration comprise de préférence entre 10 et 20 % en masse.

Selon un mode de mise en œuvre, le liquide de prétraitement contient aussi un acide fort, ce dernier permettant de favoriser la désoxydation de la brasure. Dans sa combinaison potentielle avec le chlorhydrate d'acide glutamique, cet acide permet de stabiliser le chlorhydrate d'acide glutamique. Cet acide fort est par exemple de l'acide chlorhydrique, avec une concentration comprise entre 0.1% et 1%, de préférence de l'ordre de 0.4 % en masse. Si l'acide fort est un acide fort autre que l'acide chlorhydrique, sa quantité est adaptée pour que le pH du liquide de prétraitement soit inférieur à 2.

Selon un mode de mise en œuvre, le liquide de prétraitement contient aussi un détergent acide, permettant en particulier d'améliorer le mouillage du liquide de prétraitement sur les composants et en particulier sur les bossages de brasure.

Selon un mode de mise en œuvre, les composants sont rincés immédiatement après le contact avec le liquide de prétraitement avec un bon solvant permettant de solubiliser les solutés présents dans le liquide de prétraitement à hauteur d'au moins 10%, de sorte que seul un film moléculaire adsorbé reste sur la brasure, ledit bon solvant étant par exemple de l'eau.

Selon un mode de mise en œuvre, les composants sont rincés immédiatement après le contact avec le liquide de prétraitement avec un mauvais solvant permettant de ne pas solubiliser plus de 0.1% des solutés présents dans le liquide de prétraitement, de sorte qu'un film mince d'épaisseur nanométrique, de préférence comprise entre 1 et 100 nm, reste sur les composants traités et en particulier sur les bossages de brasure, ledit mauvais solvant étant par exemple de l'isopropanol.

Selon un mode de mise en œuvre, les composants sont séchés immédiatement après le contact avec le liquide de prétraitement, de manière à laisser un film de matière, puis sont éventuellement lavés avec un mauvais solvant des solutés présents dans le liquide de prétraitement de prétraitement, de façon à réduire l'épaisseur du film laissé sur le composant après le premier séchage, pour atteindre l'épaisseur souhaitée, ledit mauvais solvant étant par exemple de l'isopropanol.

Selon un mode de mise en œuvre, le contact avec le liquide de prétraitement peut être fait par immersion et par exemple dans un bain à ultrasons, le temps de contact avec le liquide de prétraitement est de préférence compris entre 1 et 5 minutes, l'assemblage par brasage étant ensuite réalisé de préférence moins de quatre heures après le prétraitement, en présence d'air ou sous gaz neutre.

L'invention préconise l'utilisation d'un liquide de prétraitement dont le bénéfice est de pouvoir ensuite assembler les composants par brasage sans utiliser de flux liquide ou gazeux, sans laisser de résidu, et avec un bon rendement d'assemblage. En comparaison, les techniques actuelles se concentrent sur l'application locale de flux liquide (qui laisse des résidus problématiques), ou l'utilisation de flux gazeux (qui nécessitent des équipements spéciaux et un environnement sécurisé). Le procédé de la présente invention constitue un progrès technique comparativement aux techniques existantes qui ne produisent pas cette synergie de caractéristiques favorables.

### BRÈVE DESCRIPTION DES FIGURES

Les figures sont données à titre d'exemples non limitatifs, pour servir de support explicatif à la description détaillée qui suit.
La figure 1 montre une vue schématique de deux composants 10 et 20 destinés à être assemblés.
La figure 2a représente est un détail de la figure 1 montrant un exemple de réalisation des connecteurs, avec d'une part des bossages de brasure 11 sur le composant 10 et d'autre part des plots de métallisation 21 sur le composant 20. La figure 2a montre la situation avant assemblage.
La figure 2b montre la situation après assemblage, où des joints de brasure 31 lient les connecteurs 11 et 21.
La figure 3a montre une image au microscope électronique des bossages de brasure du véhicule de test n°1 discuté dans le texte.
La figure 3b montre une image au microscope électronique des plots de métallisation du véhicule de test n°1 discuté dans le texte.
La figure 4a montre la surface de puces comportant des plots de métallisation, photographiée après l'assemblage et le démontage des assemblages, dans le but de déterminer la qualité de l'assemblage.
La figure 4b montre un autre cas de surface de puces.
La figure 4c montre un autre cas de surface de puces.
La figure 4d montre un autre cas de surface de puces.
La figure 5 montre les courbes d'analyse ToF-SIMS donnant la quantité d'oxygène en fonction de la profondeur pour des bossages de brasures ayant subi différents traitements.
La figure 6 montre la puce du véhicule de test n°3 qui comporte des bossages de brasure, photographiée après le prétraitement avec le liquide de prétraitement n°3 et un rinçage à l'isopropanol (voir l'exemple n°5 du texte).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

La présente invention est un procédé d'assemblage de composants mettant en œuvre un prétraitement des bossages de brasure permettant un assemblage par brasage sans flux et sans résidu. On commence d'abord par décrire le procédé d'assemblage des composants, puis on décrira en détail le procédé de prétraitement des bossages de brasure, qui est le coeur de l'invention.

Le procédé d'assemblage consiste à assembler un premier composant portant des bossages de brasure avec un second composant portant des connecteurs. Lors de l'opération d'assemblage, les deux composants sont mis en regard de sorte que les bossages de brasure du premier composant se retrouvent au contact des connecteurs du second composant pour former des joints de brasure.

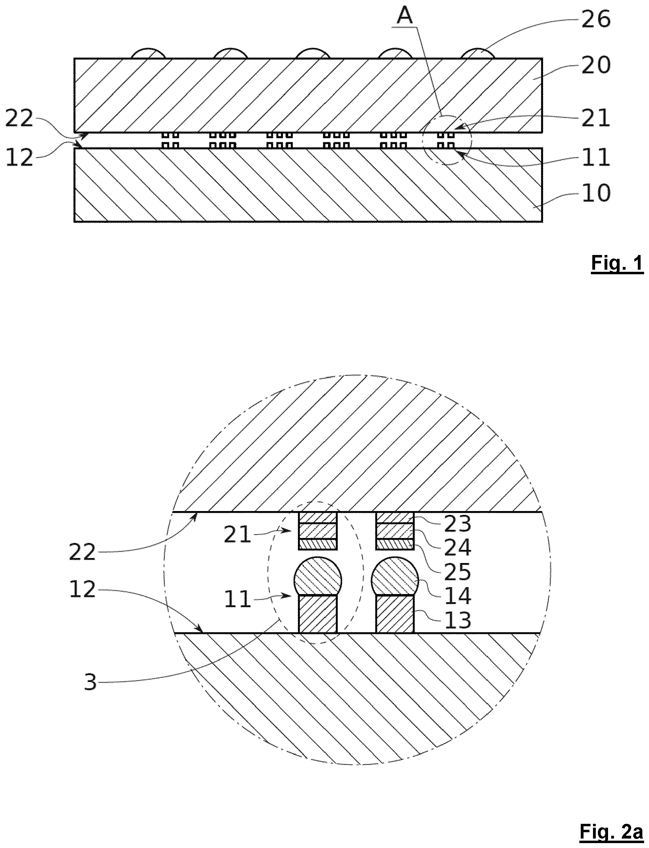

Les figures 1 et 2a fournissent un exemple schématique de composants à assembler. Un premier composant 10 est visible en partie inférieure des dessins et peut par exemple provenir d'un substrat en matériau semi-conducteur tel le silicium, ou en saphir monocristallin, ou en verre. Un deuxième composant 20, qui peut être du même type ou non, lui est superposé en vue d'un assemblage. Une face 12 du premier composant 10 se trouve ainsi en regard d'une face 22 de l'autre composant 20.

Tous types de composants employés dans la microélectronique sont visés par l'invention dès lors qu'ils impliquent une connexion électrique et/ou mécanique par des bossages de brasure présents sur au moins l'un des deux composants. Des éléments fonctionnels peuvent être présents sur chaque composant et à titre d'exemple illustratif on a représenté des fonctions optiques 26 portées par la face du deuxième composant 20 opposée à la face 22. Les fonctions optiques 26 peuvent être des microlentilles présentes sur un substrat de verre ou de silicium 20 alors que le premier composant 10 peut être un interposeur photonique.

Le terme « connecteur » s'entend de tout organe ayant une fonction de raccordement électrique et/ou une fonction de raccordement mécanique, de sorte que le raccordement de deux connecteurs produise une fonction de conduction électrique au travers des deux connecteurs assemblés et/ou une fonction de solidarisation mécanique permettant de relier de manière immobile les deux composants. Ainsi, les « bossages de brasure » sont un exemple de type de connecteurs et les « plots métalliques » sont un autre exemple de type de connecteurs.

Pour procéder à l'assemblage, les deux composants sont mis en vis-à-vis de sorte que les connecteurs des composants soient en regard, puis les composants sont rapprochés jusqu'au contact des connecteurs. On peut réaliser l'assemblage unitaire d'un seul composant sur un seul autre, ou réaliser un assemblage collectif d'une pluralité de composants sur une autre pluralité de composants. Un assemblage unitaire consiste en l'assemblage d'un seul composant sur un seul autre composant. Un assemblage collectif consiste en l'assemblage d'une pluralité de composants sur une autre pluralité de composants avec un seul cycle thermique pour l'ensemble. Dans ce cas, l'autre pluralité de composants peut être un ensemble de composants disposés sur le plateau de travail de l'équipement d'assemblage, ou bien un wafer entier posé sur le plateau de l'équipement d'assemblage (les composants pourront être individualisé par la suite en découpant le wafer), ou bien encore un ensemble de composants disposés sur une plaque indépendante (qui pourra être retirée de l'équipement d'assemblage, ce qui permet de transporter l'ensemble des composants en une fois). Notons que souvent, la fabrication des composants 20 se termine par une découpe où les composants sont individualisés et laissés sur un film adhésif avec leur face 22 orientée vers le haut. La mise en place du composant 20 sur le composant 10 nécessite donc un retournement du composant pour que la face 22 se retrouve orientée vers le bas, cette technique étant habituellement nommée « flip-chip » en anglais.

La présente invention concerne spécifiquement l'assemblage de composants grâce à des bossages de brasure présents sur au moins l'un des deux composants et ayant la fonction de connecteur. Lors de l'assemblage, les bossages de brasure présents sur l'un des composants se retrouvent en face de connecteurs présents sur l'autre composant, en vue d'être connectés l'un à l'autre par un joint de brasure. Dans l'exemple illustré sur les figures 1 et 2a, le composant 10 comporte des bossages de brasure 11 et le composant 20 comporte des plots métalliques 21. La figure 2a est une vue de détail de la structure des connecteurs avant leur assemblage. Il convient de garder à l'esprit que le connecteur 21 pourrait être un autre type de connecteur qu'un plot métallique, il pourrait par exemple être un bossage de brasure, ce qui correspondrait à un assemblage de bossage sur bossage. On a toutefois choisi de représenter la situation la plus courante qui est celle d'un assemblage de bossage sur plot métallique.

Le bossage de brasure 11 est formé par exemple d'un pilier de cuivre 13 et d'un matériau de brasure 14 qui est typiquement un alliage d'étain. Pour ce type de bossage, nommé en anglais « copper bump », le matériau de brasure est en général fabriqué par électrolyse sous la forme d'un pavé droit, puis un passage à haute température fait fondre la brasure, de sorte que les forces capillaires dans le liquide donnent à la brasure une forme bombée, qui est conservée après refroidissement. L'ensemble 11 peut faire une hauteur totale de l'ordre de 2 à 100 micromètres, où la hauteur de la base représente par exemple la moitié de la hauteur totale. L'espace entre deux bossages 11 voisins sur le même composant peut aller de 5 à 200 micromètres typiquement. De manière générale, on pourra envisager des brasures d'étain comme mentionnées ci-dessus, ou bien d'indium (généralement sous la forme de billes sans pilier de cuivre), ou bien d'un alliage à base de ces matériaux. Il pourra s'agir aussi d'alliage de plomb mais cet exemple n'est pas préféré compte-tenu des restrictions réglementaires quant à son usage.

Le connecteur 21 est par exemple un plot métallique (« pad » en anglais) qui comprend dans le cas dessiné trois couches superposées. La couche inférieure 23 est par exemple en titane avec une épaisseur de l'ordre de 200 nm ; la couche intermédiaire 24 est par exemple en nickel avec une épaisseur de l'ordre de 700 nm ; la couche supérieure est notamment en or avec une épaisseur de l'ordre de 100 nm.

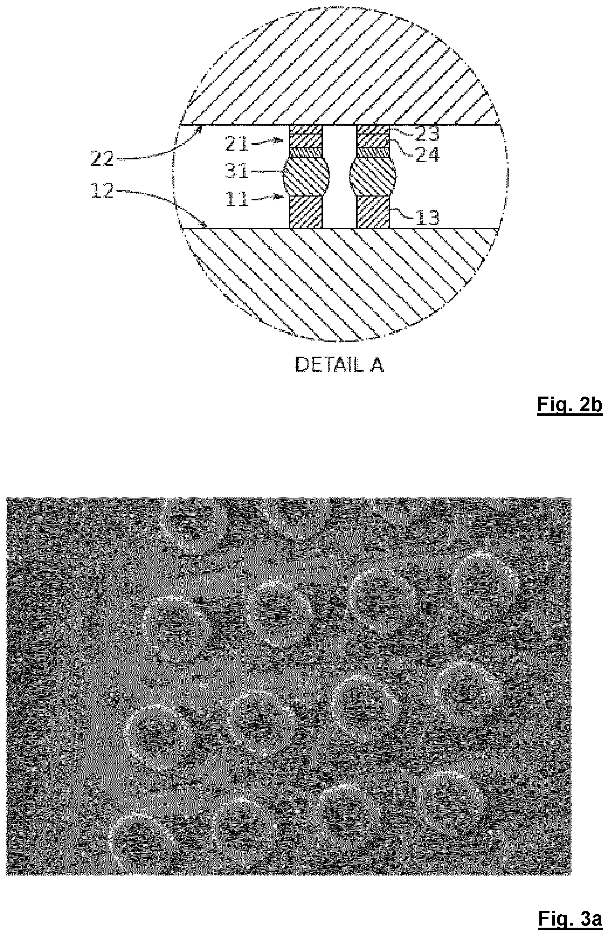

Lors de l'assemblage à haute température, la brasure du bossage passe à l'état liquide, et étant au contact du plot métallique, va mouiller la surface de ce plot. La couche d'or à la surface du plot a pour rôle de favoriser un bon mouillage, puis elle est progressivement dissoute dans le volume de brasure et formera un composé intermétallique. Après le refroidissement, la paire de connecteurs 3, composée d'un bossage de brasure 11 et d'un plot métallique 21, forme un joint de brasure solide 31 représenté sur la figure 2b. La couche d'or 25 a été retirée du schéma car l'or se retrouve inclus comme intermétallique dans le joint de brasure qui a été formé.

Le profil de température utilisé est typiquement de 250°C pendant une minute pour une brasure à base d'étain, et de 190°C pendant une minute pour une brasure d'indium, ce qui correspond à une température d'environ 30°C au-dessus de la température de fusion des brasure d'étain ou d'indium, donnant une marge de sécurité suffisante pour s'assurer que les conditions de fusion de la brasure soient bien atteintes. Les paragraphes suivants exposent le détail du procédé d'assemblage en ce qui concerne la mise en place des composants et l'application du profil de température. Cela peut être réalisé de différentes manières connues dans l'état de l'art, en utilisant les équipements d'assemblage disponibles dans le domaine de la microélectronique.

Une première façon de procéder consiste à tenir chaque composant pour les placer l'un en face de l'autre et les rapprocher au cours de l'application du profil de température. En général, la dispersion de la hauteur des bossages et des plots métalliques sur les composants approvisionnés, ainsi que le défaut de planéité des composants, ne permet pas que toutes les paires de connecteurs 3 entrent simultanément en contact. Seulement une fraction des paires de connecteurs sont initialement en contact et empêchent par leur résistance mécanique un rapprochement plus étroit des composants et donc des autres paires de connecteurs. Lorsque le profil de température est appliqué, la brasure des bossages fond et mouille le connecteur en regard pour les paires qui sont initialement en contact. Pour raccorder les paires de connecteurs qui n'étaient initialement pas en contact, on programme l'équipement d'assemblage pour qu'il tende à rapprocher les connecteurs, en lui demandant par exemple d'appliquer une certaine force. Lorsque la brasure des bossages fond, sa résistance mécanique diminue, ce qui autorise le rapprochement des composants sous l'effet de la force appliqué, permettant ainsi que toutes les paires de connecteurs entrent en contact et se raccordent. L'homme de l'art saura choisir la force adéquate, suffisante pour permettre une connexion de tous les connecteurs, mais toutefois limitée pour éviter d'appuyer trop fort et éviter d'expulser la brasure liquide sur le côté des bossages.

Une seconde façon de procéder consiste à maintenir le composant 10 fixe, à aligner le composant 20 au-dessus du composant 10, puis à le poser sur le composant 10, et à le lâcher de sorte qu'il n'est alors plus tenu. Lorsque le profil de température est appliqué, la brasure des bossages fond et mouille le connecteur en regard pour les paires qui sont initialement en contact. La géométrie de la brasure, initialement bombée comme une calotte sphérique, tend à prendre une forme de tonneau après avoir mouillé le plot en regard, en même temps que les forces capillaires dans la brasure liquide tendent à diminuer l'écart entre les surfaces 12 et 22 qui sont en regard lors du procédé. Cet effet de rapprochement est important car la dispersion des hauteurs des bossages et des plots sur les composants à traiter, ainsi que les défauts de planéité des composants, ne permettent pas que toutes les paires de connecteurs 3 soient initialement en contact. Bien que seule une fraction des paires 3 soit initialement en contact, le mouillage de la brasure et les forces capillaires associée causent un rapprochement qui met progressivement les autres paires de connecteurs en contact, aboutissant à la formation de joints pour toutes les paires de connecteurs. Il peut arriver toutefois que la dispersion des hauteurs des bossages et des plots sur les composants approvisionnés soit trop importante, et que le rapprochement des composants grâce au mouillage de la brasure ne permette pas de rattraper tous les écarts de hauteur. Dans ce cas, il peut être utile de procéder, avant l'étape d'assemblage en température, à une étape de mise à niveau des bossages de brasure, appelée « coining » en anglais, lors de laquelle les deux composants avec leurs connecteurs en regard sont appuyés l'un sur l'autre avec une force suffisante pour permettre la déformation plastique de la brasure et sa mise à niveau. Cette mise à niveau des bossages de brasure peut aussi se faire en appuyant les bossages contre une plaque plane. Les matériaux de brasure se prêtent en général bien à cette étape de mise à niveau car ce sont des matériaux ductiles. Un avantage du procédé qui vient d'être décrit, dans lequel le composant du dessus n'est pas tenu lors de l'étape à haute température, est que ce composant peut s'aligner tout seul grâce aux forces capillaires de la brasure liquide, dans le sens où ces forces tendent à amener les connecteurs 21 à la verticale des connecteurs 11. Cet effet d'auto-alignement permet d'atteindre une précision d'alignement inférieure au micromètre même si le composant du dessus était préalablement posé avec une précision plus grossière, caractérisée par une incertitude de plusieurs microns. D'autre part, dans le cas d'un assemblage collectif, le procédé qui vient d'être décrit permet de déposer une pluralité de composants 20 sur une pluralité de composants 10, puis d'effectuer un unique cycle thermique pour assembler tous ces composants en même temps grâce à une fusion collective de la brasure des bossages.

La présente invention est un procédé d'assemblage de composants mettant en œuvre un prétraitement des bossages de brasure permettant un assemblage par brasure sans flux et sans résidu. Après avoir décrit le procédé d'assemblage dans les paragraphes précédents, on décrit maintenant le procédé de prétraitement qui constitue le cœur de l'invention. Comme il a été expliqué dans l'arrière-plan technologique, un traitement des bossages de brasure est indispensable pour arriver à former des joints de brasure corrects et atteindre un bon rendement d'assemblage. Le traitement le plus courant consiste à appliquer un flux liquide sur les composants avant de les assembler, malheureusement ce procédé laisse des résidus de flux après l'assemblage. Ces résidus sont acceptables dans certaines situations mais inacceptables dans d'autres situations. On renvoie pour cette discussion à la lecture de l'arrière-plan technologique. La présente invention propose un procédé de prétraitement à effectuer avant l'assemblage des composants et dont le bénéfice est de pouvoir réaliser ensuite les assemblages sans utiliser de flux liquide ou gazeux.

Avant l'assemblage proprement dit, la présente invention consiste à mettre en contact les composants portant des bossages de brasure avec un liquide de prétraitement. Ce contact est par exemple réalisé par une immersion des composants dans le liquide de prétraitement, l'important étant que les bossages de brasure soient en contact avec le liquide. La formulation du liquide de prétraitement est choisie pour que le temps de contact soit de préférence compris entre 1 et 5 minutes, pour être compatible avec les cadences industrielles tout en permettant un contrôle précis du temps de traitement. L'application d'ultrasons dans le liquide de prétraitement peut être utile pour améliorer l'homogénéité du traitement sur les composants et diminuer le temps de contact nécessaire pour atteindre le bénéfice attendu du prétraitement. Les composants sont ensuite rincés et séchés avant de procéder à leur assemblage.

Une première formulation de liquide de prétraitement consiste à utiliser une solution détergente basique, dont le pH est de préférence compris entre 11 et 13. Selon cette préconisation, on considère un exemple nommé LIQUIDE DE PRÉTRAITEMENT N°1 et formé en diluant le détergent basique TFD7 de la société Franklab à hauteur de 3% dans l'eau. C'est une solution aqueuse de pH 12. Le détergent utilisé est à base d'EDTA (Éthylènediaminetétraacétique), de pyrophosphate de sodium et d'hydroxyde de potassium.

Une deuxième formulation de liquide de prétraitement consiste à utiliser une solution détergente acide, dont le pH est de préférence compris entre 1 et 3. Selon cette préconisation, on considère un exemple nommé LIQUIDE DE PRÉTRAITEMENT N°2 et formé en diluant le détergent acide Neutrax PF de la société Franklab à hauteur de 3% dans l'eau. C'est une solution aqueuse de pH 3. Le détergent utilisé est à base d'acide acétique et d'acide citrique.

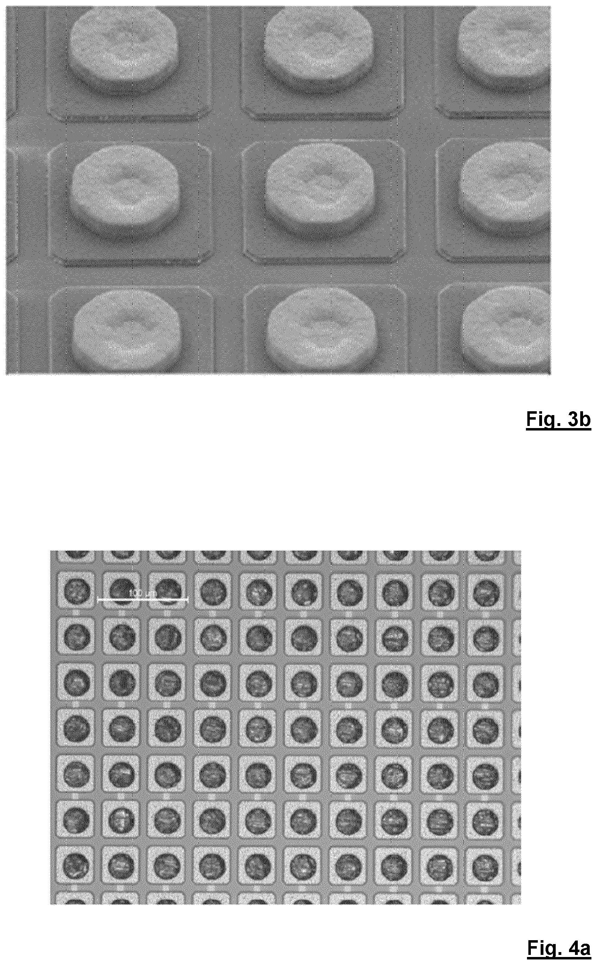

Pour tester et comparer les différents procédés, on a utilisé un VÉHICULE DE TEST N°1 formé de deux puces en silicium destinées à être assemblées l'une sur l'autre. La première puce comporte des bossages de brasure qui sont des piliers de cuivre surmontés d'une brasure à base d'étain (Sn 98%, Ag 2%). Les piliers ont un diamètre de 25 µm et sont disposés selon un réseau carré avec un pas de 50 µm. La hauteur des piliers de cuivre est de 12 µm et la brasure forme un dôme d'une hauteur de 11 µm au sommet des piliers. La taille de cette première puce est de 5 mm sur 6 mm, avec une épaisseur de 200 µm. La deuxième puce comporte des plots de métallisation de 27 µm de diamètre, formés par une couche de nickel de 3 µm d'épaisseur surmontée d'une couche superficielle d'or. La disposition des plots de métallisation sur la deuxième puce coïncide avec la disposition des bossages de brasure de la première puce, pour permettre leur assemblage lorsque les puces sont mises en regard. La deuxième puce fait 11 mm par 11 mm, avec une épaisseur de 725 µm. Elle est plus grande que la première, pour permettre une manipulation plus facile lors des essais, et sera placée en dessous de la première puce lors des assemblages. Des images des deux puces obtenues par microscopie électronique à balayage sont présentées en figure 3 et montrent les connecteurs des deux puces. L'image de gauche montre les bossages de brasure, et l'image de droite montre les plots de métallisation.

Dans un EXEMPLE N°1, on réalise le prétraitement des puces du véhicule de test n°1. Les puces qui comportent des bossages de brasure sont immergées dans le liquide de prétraitement n°1 ou n°2 pendant 3 minutes dans un bain à ultrasons. Elles sont ensuite rincées à l'eau puis séchées avec un souffle d'azote. Les bossages de brasure sont ensuite observés au microscope optique, au microscope électronique et leur hauteur avant et après le prétraitement est mesurée à l'aide d'un profilomètre optique interférométrique. L'observation au microscope optique et au microscope électronique ne montre pas de changement visible à la suite du prétraitement. En mesurant la hauteur du sommet des bossages avant et après prétraitement, on observe une légère diminution de la hauteur moyenne des bossages, de l'ordre de 10 à 20 nm. Cette valeur est très faible par rapport à la hauteur de 11 µm de la brasure des bossages, et l'ensemble des observations permettent de conclure que le prétraitement par les liquides n°1 ou n°2 dans les conditions de cet exemple ne dégradent pas les bossages de brasure.

Les détergents sont de préférence de type non moussant pour permettre un rinçage rapide et efficace, et c'est le cas des détergents utilisés pour les liquides de prétraitement n°1 et n°2.

Dans un EXEMPLE N°2, on réalise le prétraitement des puces du véhicule de test n°1 de la même façon que dans l'exemple n°1, puis on effectue leur assemblage par brasage par les opérations suivantes dans un délai de moins d'une heure après le prétraitement. La puce comportant les bossages de brasure est positionnée au-dessus la puce comportant les plots de métallisation avec une précision de 5 µm ou mieux, puis un appui à froid est réalisé pour mettre à niveau la brasure des bossages par rapport aux plots de métallisation (voir plus haut la discussion sur ce procédé de « coining »). La puce du dessus est ensuite lâchée et un cycle thermique est effectué avec une montée en température à 250°C qui permet la fusion de la brasure et son mouillage sur les plots de métallisation en regard, l'opération se faisant sous une atmosphère inerte d'azote. Après le refroidissement, les assemblages sont démontés en poussant latéralement la puce du dessus tout en maintenant la puce du dessous fixe pour générer une contrainte de cisaillement permettant de séparer les deux puces. Une observation au microscope optique des connecteurs des deux puces après leur séparation permet de déterminer si les paires de connecteurs avaient formé des joints de brasure corrects ou bien si certaines paires n'étaient pas connectées après le procédé. En particulier, l'observation de l'aspect des plots de métallisation après le démontage permet de savoir clairement si un joint de brasure avant mouillé et adhéré au plot. En effet, si c'est le cas, la brasure reste en partie accrochée au plot après le démontage, et si ce n'est pas le cas, la couche d'or reste visible sur le plot. La photo de la figure 4a correspond à la puce comportant les plots de métallisation après les opérations suivantes : prétraitement avec le liquide de prétraitement n°1, assemblage comme mentionné plus haut dans cet exemple, puis démontage. On constate que tous les plots visibles sur cette photo ont été correctement mouillés. Les puces sont déclarées avoir été assemblées correctement lorsque toutes les paires de connecteurs ont formé des joints de brasure corrects. Avec le procédé décrit dans cet exemple, que ce soit en utilisant le liquide de prétraitement n°1 ou avec le liquide n°2, on observe que l'on atteint un rendement d'assemblage de 100%.

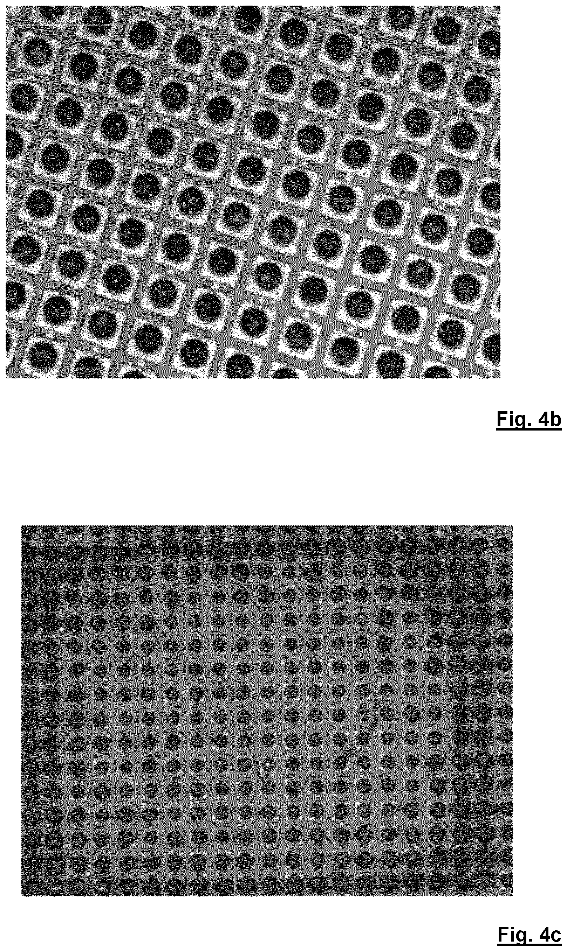

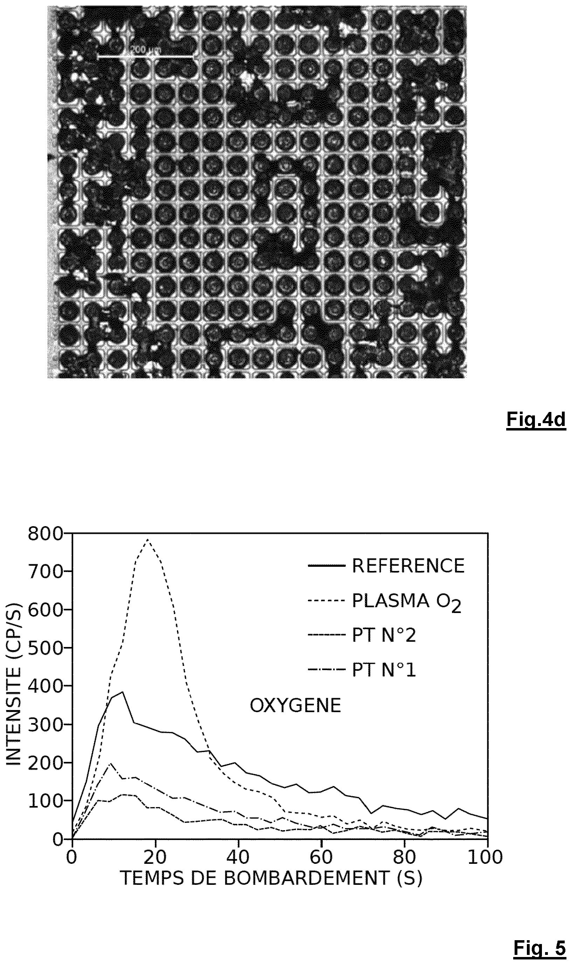

Dans un but de comparaison, les puces du véhicule de test n°1 sont également assemblées en utilisant d'autres procédés de traitement des bossages de brasure. Dans un premier exemple comparatif, on remplacera le liquide de prétraitement par une solution aqueuse d'acide chlorhydrique à 0.1 mol/L. Dans un deuxième exemple comparatif, on effectuera l'assemblage sous une atmosphère réductrice contenant de la vapeur d'acide formique diluée dans l'azote à deux concentrations différentes. Dans un troisième exemple comparatif, on utilisera des flux liquides de type « ORL0 » et « ORM1 », correspondant à des activités croissantes selon la classification de la norme IPC-J-STD-004. Hormis cela, le procédé d'assemblage des puces restera le même que dans l'exemple n°2, avec le même profil de température et le même test pour déterminer le rendement de l'assemblage des puces. Les résultats obtenus sont donnés dans le tableau ci-dessous. La quantité de résidus mentionnée est une évaluation qualitative donnée à partir de l'observation visuelle des puces, dont certains exemples sont montrés sur la figure 4, en particulier la photo 4a correspond à l'utilisation du liquide de prétraitement n°1, la photo 4b correspond à l'utilisation de l'acide formique vapeur à 2 %, la photo 4c correspond à l'utilisation d'un flux liquide « ORL0 », et la photo 4d correspond à l'utilisation d'un flux liquide « ORM1 ». On constate que l'acide chlorhydrique ne permet pas d'atteindre le même bénéfice que les liquides de prétraitement n°1 et n°2 car dans des conditions expérimentales identiques il ne permet pas d'assembler les puces en formant de façon répétable des joints de brasure pour toutes les paires de connecteurs, c'est-à-dire qu'il reste toujours des paires non connectées (environ 20%). On constate que l'acide formique vapeur à une concentration de 8% permet un assemblage aussi efficace et propre qu'avec les deux prétraitements. Par contre, l'acide formique gazeux est un gaz inflammable et toxique, son utilisation nécessite des équipements spéciaux et des détecteurs de gaz pour assurer la sécurité de l'environnement de travail. En comparaison, le procédé de la présente invention a l'avantage de ne pas présenter ces inconvénients tout en donnant la même qualité de résultat. Concernant l'utilisation des flux liquides, on constate que seule l'utilisation d'un flux suffisamment actif permet d'obtenir un rendement d'assemblage de 100%, mais que ce procédé laisse une quantité importante des résidus de flux comme on le voit sur la figure 4d. En comparaison, le procédé de la présente invention a l'avantage de laisser les surfaces propres sans résidu.

**Tableau 1**

| **Procédé** | **Rendement d'assemblage** | | **Quantité de résidus** |
|---|---|---|---|
| Liquide de prétraitement n°1 | | 100 % | 0 |
| Liquide de prétraitement n°2 | | 100 % | 0 |
| Prétraitement HCI 0.1 mol/L | | 0% | 0 |
| Acide formique vapeur 2 % | | 20 % | 0 |
| Acide formique vapeur 8 % | | 100 % | 0 |
| Flux liquide « no clean » ORL0 | | 60 % | 1 |
| Flux liquide « no clean » ORM1 | | 100 % | 2 |

Pour déterminer l'action physico-chimique des traitements réalisés sur la brasure des bossages, on a utilisé la technique de ToF-SIMS (« Time of Flight - Secondary Ion Mass Spectroscopy ») qui consiste à creuser la surface de l'échantillon par un bombardement d'ions (Cs⁺ dans notre cas) et à analyser les ions provenant de l'échantillon et éjectés par ce bombardement. Cette technique permet de déterminer la composition chimique de l'échantillon en fonction de la profondeur d'abrasion. La figure 5 montre le résultat obtenu pour la mesure de l'oxygène au niveau de la surface de la brasure des puces du véhicule test n°1. Différents échantillons sont analysés : un échantillon de référence non traité, un échantillon traité par un plasma d'oxygène (RIE), et deux échantillons traités par les liquides de prétraitement n°1 et n°2 selon le procédé décrit dans l'exemple n°1. On constate que les liquides de prétraitement ont pour effet de réduire largement la quantité d'oxygène initialement présente à la surface de la brasure. Une analyse similaire peut être effectuée pour la mesure du carbone au niveau de la surface de la brasure et on constate que les deux liquides de prétraitement ont également pour effet de réduire largement la contamination carbonée initialement présente à la surface de la brasure. Cette contamination carbonée est une contamination organique qui s'accumule simplement par le fait de laisser les puces à l'air, même dans l'atmosphère d'une salle blanche. On constate donc que l'action des liquides de prétraitement n°1 et 2 réduit l'épaisseur de la couche d'oxyde et réduit la contamination carbonée à la surface de la brasure. En comparaison, le plasma d'oxygène a également cet effet, mais il réduit moins l'épaisseur de la couche d'oxyde, ce qui n'en fait pas un prétraitement efficace. En comparaison, un prétraitement à l'acide chlorhydrique comme évoqué plus haut n'est pas non plus un bon prétraitement car s'il diminue bien l'épaisseur d'oxyde, il est moins efficace sur le retrait de la contamination carbonée. C'est donc l'effet conjoint de l'action corrosive sur la couche d'oxyde et de la réduction de la contamination carbonée qui permet au prétraitement de l'invention d'être efficace.

On considère ensuite un VÉHICULE DE TEST N°2 formé de deux puces en silicium destinées à être assemblées l'une sur l'autre. La première puce comporte des bossages de brasure qui sont des billes d'indium de 15 µm de diamètre, disposées selon un réseau carré avec un pas de 30 µm. La deuxième puce comporte des plots de métallisation formés par une couche de titane de 50 nm, une couche de platine de 250 nm et une couche superficielle d'or de 100 nm. La disposition des plots de métallisation sur la deuxième puce coïncide avec la disposition des bossages de brasure de la première puce, pour permettre leur assemblage lorsque les puces sont mises en regard.

Dans un EXEMPLE N°3, on réalise le prétraitement des puces du véhicule de test n°2. Les puces qui comportent des bossages de brasure sont immergées dans le liquide de prétraitement n°2 pendant 3 minutes dans un bain à ultrasons. Elles sont ensuite rincées à l'eau puis séchées avec un souffle d'azote. Une observation des billes de brasure au microscope optique montre qu'elles ne sont pas dégradées par ce traitement. On effectue ensuite l'assemblage par brasage des deux puces du véhicule de test n°2 par les opérations suivantes dans un délai de moins d'une heure après le prétraitement. Les puces sont mises en regard avec une précision de 5 µm ou mieux, puis un appui à froid est réalisé pour mettre à niveau la brasure des bossages par rapport aux plots de métallisation (voir plus haut la discussion sur ce procédé de « coining »). La puce du dessus est ensuite lâchée et un cycle thermique est effectué avec une montée en température à 200°C qui permet la fusion de la brasure d'indium et son mouillage sur les plots de métallisation en regard, l'opération se faisant sous une atmosphère inerte d'azote. Après le refroidissement, les assemblages sont démontés et les puces sont inspectées pour déterminer le bon mouillage de la brasure comme expliqué dans l'exemple n°2. On constate que le procédé permet d'atteindre un rendement d'assemblage de 100 %, au sens où toutes les paires de connecteurs forment des joints corrects. Ceci montre que le prétraitement de la présente invention est également efficace sur les brasures à l'indium.

L'invention assure donc à la fois un assemblage par brasage optimal (rendement d'assemblage de 100 %) et un état de surface de très bonne qualité sur l'ensemble du composant (ce qui est un avantage sur les flux liquide), tout en évitant l'utilisation de gaz inflammables ou toxiques (ce qui est un avantage sur les traitements gazeux ou par plasma).

La durée de l'effet des liquides de prétraitement n°1 et n°2 est typiquement de l'ordre d'une heure, c'est-à-dire qu'il faut de préférence réaliser l'assemblage moins d'une heure après le prétraitement. Pour augmenter cette durée, on a développé des liquides de prétraitement permettant de laisser un film mince sur la surface des composants traités, d'une épaisseur de préférence inférieure à 100 nm, ce film ayant la propriété de favoriser un brasage efficace sans pour autant laisser de résidus après assemblage. En particulier, les solutions aqueuses contenant des acides carboxyliques, des diacides carboxyliques, ou plus généralement des polyacides carboxyliques sont avantageuses. En effet les acides carboxyliques sont corrosifs de par leur fonction acide et leur utilisation en prétraitement permet donc de réduire l'épaisseur de la couche d'oxyde présente initialement sur la brasure. Mais aussi, le groupement acide carboxylique a la possibilité de s'adsorber sur la surface de la brasure par complexation, pour ensuite s'exprimer comme agent réducteur lors de la montée en température au cours de l'assemblage (de manière similaire à l'action de l'acide formique vapeur à chaud). La solution pourra avantageusement contenir des aminés, des diamines ou plus généralement des polyamines, qui sont connues comme catalyseur de par leur effet complexant. De manière plus avantageuse, la solution pourra contenir des acides aminés ou des diacides aminés, qui combinent les fonctions acide carboxylique et amine. En particulier, il est avantageux de considérer une solution aqueuse contenant du chlorhydrate d'acide glutamique, dans une concentration comprise de préférence entre 10 et 20%. Il est aussi avantageux d'ajouter un acide fort pour favoriser la désoxydation de la brasure, et aussi pour stabiliser le chlorhydrate d'acide glutamique.

Selon ces préconisations, on considère un exemple nommé LIQUIDE DE PRÉTRAITEMENT N°3 constitué d'une solution aqueuse contenant 14% de chlorhydrate d'acide glutamique et 0.4% d'acide chlorhydrique. L'acide chlorhydrique est un acide fort qui permet d'une part d'accentuer le caractère corrosif du liquide de prétraitement et donc sa capacité à dissoudre la couche d'oxyde initialement présente sur la brasure, et d'autre part de stabiliser le chlorhydrate d'acide glutamique. En effet, si on laisse à l'air une solution de chlorhydrate d'acide glutamique non acidifiée, une partie du chlorure d'hydrogène du chlorhydrate s'évapore progressivement, ce qui diminue l'acidité et laisse précipiter l'acide glutamique. L'acidification de la solution permet donc de la stabiliser en évitant sa précipitation, ce qui est un avantage pratique en termes de durée de vie et de mise en oeuvre.

Dans un EXEMPLE N°4, les puces du véhicule de test n°1 sont immergées dans le liquide de prétraitement n°3 pendant 5 minutes dans un bain (sans ultrasons). Elles sont ensuite rincées à l'eau puis séchées avec un souffle d'azote. De la même manière que dans l'exemple n°1 détaillé plus haut, on vérifie que le procédé de prétraitement avec ce liquide ne dégrade pas les bossages de brasure. On vérifie également à l'aide de la technique de ToF-SIMS que ce prétraitement réduit l'épaisseur de la couche d'oxyde et la quantité de contamination carbonée initialement présentes sur la brasure. De la même manière que dans l'exemple n°2, on réalise des assemblages par brasage en attendant moins d'une heure après avoir effectué le prétraitement. On obtient un rendement d'assemblage de 100% et on observe que les puces ne présentent aucun résidu visible après leur démontage, ce qui valide l'efficacité du liquide de prétraitement n°3. Par ailleurs, la force de cisaillement mesurée lors du démontage des puces est supérieure avec ce liquide de prétraitement en comparaison avec l'utilisation des liquides de prétraitement n°1 et n°2. Ce résultat peut être attribué au fait que le liquide de prétraitement n°3 laisse sur la brasure un film adsorbé qui favorise la désoxydation de la brasure lors de l'étape d'assemblage à haute température.

L'ajout d'un détergent acide comme par exemple le Neutrax PF de la société Franklab à hauteur de 0.8% dans le liquide de prétraitement n°3 permet un meilleur mouillage du liquide sur les composants comportant des bossages de brasure, ce qui permet en particulier d'assurer une bonne homogénéité du contact du liquide sur les composants et notamment sur les bossages de brasure, en évitant les bulles. Le détergent mentionné comme exemple dans ce paragraphe est en fait celui utilisé pour former le liquide de prétraitement n°2, il permet donc aussi de participer à l'attaque de la couche d'oxyde initialement présente sur la brasure et au retrait de la contamination organique.

Dans l'exemple n°4, le rinçage du liquide de prétraitement est effectué avec de l'eau, qui est un bon solvant des solutés présents dans la solution de prétraitement. Ainsi, seul un film moléculaire adsorbé reste sur la brasure après le rinçage. On peut au contraire rincer les composants avec un mauvais solvant des solutés présents dans la solution de prétraitement, de sorte qu'un film mince d'épaisseur nanométrique (comprise entre 1 et 100 nm), plus épais qu'un simple film adsorbé, reste sur les composants traités et en particulier sur les bossages de brasure.

On considère un VÉHICULE DE TEST N°3 formé de deux puces en silicium destinées à être assemblées l'une sur l'autre. La première puce comporte des bossages de brasure qui sont des piliers de cuivre surmontés d'une brasure à base d'étain (Sn 98%, Ag 2%). Les piliers sont disposés selon un réseau carré avec un pas de 30 µm. La hauteur totale des piliers et du dôme de brasure qui les surmonte est de 24 µm. La deuxième comporte des plots de métallisation dont la disposition coïncide avec la disposition des bossages de brasure de la première puce, pour permettre leur assemblage lorsque les puces sont mises en regard. Cette deuxième puce, plus grande, sera placée en dessous de la première lors des opérations d'assemblage.

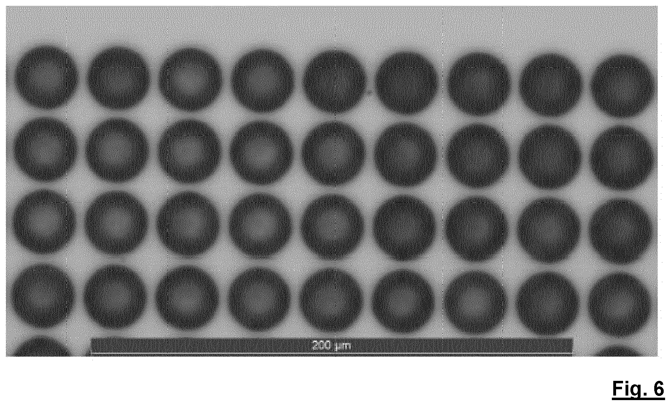

Dans un EXEMPLE N°5, les puces du véhicule de test n°3 qui comportent des bossages de brasure sont immergées dans le liquide de prétraitement n°3 pendant 5 minutes dans un bain (sans ultrasons). Elles sont ensuite rincées à l'isopropanol puis séchées avec un souffle d'azote. En observant les puces traitées de cette façon, on peut distinguer une modification de la teinte des puces entre avant et après le traitement. Cette modification de teinte est due au film mince laissé par le liquide de prétraitement après le rinçage à l'isopropanol. La couleur provient des interférences lumineuses dans le film, c'est donc une couleur interférentielle. La photographie de la figure 6 est prise au bord de la matrice de bossages de brasure et l'on peut distinguer sur le haut de la figure une légère variation de teinte à l'approche des bossages, qui caractérise une variation de l'épaisseur du film. La teinte prise par la puce est compatible avec un film d'épaisseur de quelques dizaines de nanomètres.

On réalise ensuite l'assemblage par brasage des puces du véhicule de test n°3, dans un délai de moins de 4 heures après le prétraitement décrit dans le paragraphe précédent, en utilisant le liquide de prétraitement n°3. Une mise à niveau des bossages est effectuée en appuyant la puce comportant les bossages de brasure sur la puce comportant les plots de métallisation après que les puces et leurs connecteurs aient été mis en regard (procédé de « coining »). La puce du dessus est ensuite lâchée, et un cycle thermique est alors effectué, dans l'air ambiant, avec un pic de température à 250°C pendant 60 secondes, qui assure la bonne fusion de la brasure des bossages. Après le refroidissement, les assemblages sont démontés et les puces sont inspectées pour déterminer le bon mouillage de la brasure comme expliqué dans l'exemple n°2. On constate que le procédé permet d'obtenir un rendement d'assemblage de 100% et de ne pas laisser de résidus, ce qui valide l'efficacité du procédé de cet exemple n°5, utilisant le liquide de prétraitement n°3 et un rinçage à l'isopropanol. La durée d'efficacité du traitement est passée de 1 à 4 heures en comparaison avec les exemples n°2 et 4, ce qui laisse plus de temps pour réaliser les assemblages et constitue donc un avantage pratique. De plus, contrairement aux exemples n°2 et 4, l'assemblage peur être fait de façon fiable dans l'air ambiant (une atmosphère de gaz neutre n'est pas nécessaire), ce qui est un autre avantage pratique. Ces avantages sont procurés par la présence d'un film mince d'épaisseur nanométrique (comprise entre 1 et 100 nm) sur la surface des composants traités et en particulier sur les bossages de brasure.

## Revendications

1. Procédé d'assemblage par bossages de brasure, permettant d'assembler un premier composant (10) comportant des bossages de brasure (11) avec un second composant (20) comportant des connecteurs (21), l'assemblage des composants est précédé d'un prétraitement des composants lors duquel les bossages de brasure (11) sont mis en contact avec un liquide de prétraitement configuré pour retirer au moins en partie la couche d'oxyde initialement présente sur la brasure, et l'assemblage des composants est réalisé après le prétraitement en l'absence de flux liquide ou gazeux, et éventuellement sous atmosphère de gaz neutre tel que de l'azote, ledit procédé étant **caractérisé en ce que** le liquide de prétraitement est une solution aqueuse contenant des acides carboxyliques ou des polyacides carboxyliques.

2. Procédé selon la revendication 1, dans lequel la mise en contact avec le liquide de prétraitement est configurée pour laisser un film mince sur la surface des composants (10, 11) traités, d'une épaisseur inférieure à 100 nm, ce film ayant la propriété de favoriser un brasage efficace sans pour autant laisser de résidus après assemblage, et de permettre de prolonger l'action du prétraitement de sorte que le brasage puisse être fait plus d'une heure après le prétraitement sans diminution du rendement d'assemblage.

3. Procédé selon l'une des revendications précédentes, la solution aqueuse contenant des amines ou des polyamines.

4. Procédé selon l'une des revendications précédentes, la solution aqueuse contenant des acides aminés ou des polyacides aminés.

5. Procédé selon l'une des revendications précédentes, dans lequel le liquide de prétraitement est une solution aqueuse contenant du chlorhydrate d'acide glutamique, dans une concentration comprise entre 10 et 20% en masse.

6. Procédé selon, l'une quelconque des revendications précédentes, dans lequel le liquide de prétraitement contient un acide fort en quantité suffisante pour que le liquide de prétraitement atteigne un pH inférieur à 2, cet acide fort étant par exemple l'acide chlorhydrique, avec une concentration comprise entre 0.1% et 1% en masse.

7. Procédé selon l'une des revendications précédentes, dans lequel le liquide de prétraitement contient un détergent acide.

8. Procédé selon l'une des revendications précédentes, dans lequel les composants (10, 11) sont rincés immédiatement après le contact avec le liquide de prétraitement avec un bon solvant permettant la solubilisation des solutés présents dans le liquide de prétraitement à hauteur d'au moins 10%, de sorte que seul un film moléculaire adsorbé reste sur la brasure, ledit bon solvant étant par exemple de l'eau.

9. Procédé selon l'une des revendications précédentes, dans lequel les composants (10,20) sont rincés immédiatement après le contact avec le liquide de prétraitement avec un mauvais solvant permettant la solubilisation à moins de 0.1% des solutés présents dans le liquide de prétraitement, de sorte qu'un film mince d'épaisseur nanométrique comprise entre 1 et 100 nm, reste sur les composants traités, ledit mauvais solvant étant par exemple l'isopropanol.

10. Procédé selon l'une des revendications 1 à 8, dans lequel les composants (10,20) sont séchés immédiatement après le contact avec le liquide de prétraitement, puis sont lavés avec un mauvais solvant des solutés présents dans le liquide de prétraitement, ledit mauvais solvant étant par exemple de l'isopropanol.

11. Procédé selon l'une des revendications précédentes, dans lequel le contact avec le liquide de prétraitement est fait par immersion et par exemple dans un bain à ultrasons, le temps de contact avec le liquide de prétraitement est compris entre 1 et 5 minutes, l'assemblage par brasage étant ensuite réalisé moins de quatre heures après le prétraitement, en présence d'air ou sous gaz neutre.

12. Procédé selon la revendication 3, dans lequel le liquide de prétraitement est une solution contenant un détergent basique, le pH de ladite solution étant compris entre 11 et 13.

13. Procédé selon la revendication 1, dans lequel le liquide de prétraitement est une solution contenant un détergent acide, le pH de ladite solution étant compris entre 1 et 3.

14. Procédé selon les revendications 12 ou 13 dans lequel le détergent est non moussant, le contact avec le liquide de prétraitement peut être fait par immersion et par exemple dans un bain à ultrasons, le temps de contact avec le liquide de prétraitement est compris entre 1 et 5 minutes, le contact avec le liquide de prétraitement est suivi d'un rinçage, fait par exemple avec de l'eau ou de l'isopropanol, puis d'un séchage, l'assemblage par brasage étant ensuite réalisé moins d'une heure après le prétraitement et de préférence sous une atmosphère de gaz neutre.

## Patentansprüche

1. Verfahren zum Zusammensetzen durch Lötbuckel, das es ermöglicht, eine erste Komponente (10), die Lötbuckel (11) beinhaltet, mit einer zweiten Komponente (20), die Steckverbinder (21) beinhaltet, zusammenzusetzen, wobei der Zusammensetzung der Komponenten eine Vorbehandlung der Komponenten vorangeht, bei der die Lötbuckel (11) in Kontakt mit einer Vorbehandlungsflüssigkeit gebracht werden, die konfiguriert ist, um die ursprünglich auf der Lötung vorhandene Oxidschicht mindestens teilweise zu entfernen, und die Zusammensetzung der Komponenten nach der Vorbehandlung in Abwesenheit eines Flüssigkeits- oder Gasstroms, und eventuell unter Neutralgasatmosphäre, wie Stickstoff, ausgeführt wird, wobei das Verfahren **dadurch gekennzeichnet ist, dass** die Vorbehandlungsflüssigkeit eine wässrige Lösung ist, die Carboxylsäuren oder Polycarboxylsäuren enthält.

2. Verfahren nach Anspruch 1, wobei das In-Kontakt-bringen mit der Vorbehandlungsflüssigkeit konfiguriert ist, um einen dünnen Film auf der Oberfläche der behandelten Komponenten (10, 11) mit einer Dicke von weniger als 100 nm zu belassen, wobei dieser Film die Eigenschaft aufweist, ein effizientes Löten zu fördern, ohne jedoch nach dem Zusammensetzen Reste zu hinterlassen, und es zu ermöglichen, die Wirkung der Vorbehandlung derart zu verlängern, dass die Lötung mehr als eine Stunde nach der Vorbehandlung durchgeführt werden kann, ohne die Zusammensetzungsleistung zu mindern.

3. Verfahren nach einem der vorstehenden Ansprüche, wobei die wässrige Lösung Amine oder Polyamine enthält.

4. Verfahren nach einem der vorstehenden Ansprüche, wobei die wässrige Lösung Aminosäuren oder Polyaminosäuren enthält.

5. Verfahren nach einem der vorstehenden Ansprüche, wobei die Vorbehandlungsflüssigkeit eine wässrige Lösung ist, die Glutaminsäurechlorhydrat mit einer Konzentration enthält, die zwischen 10 und 20 Masse-% liegt.

6. Verfahren nach einem der vorstehenden Ansprüche, wobei die Vorbehandlungsflüssigkeit eine starke Säure in ausreichender Menge enthält, damit die Vorbehandlungsflüssigkeit einen pH-Wert von unter 2 erreicht, wobei diese starke Säure beispielsweise Salzsäure mit einer Konzentration ist, die zwischen 0,1 Masse-% und 1 Masse-% liegt.

7. Verfahren nach einem der vorstehenden Ansprüche, wobei die Vorbehandlungsflüssigkeit ein saures Reinigungsmittel enthält.

8. Verfahren nach einem der vorstehenden Ansprüche, wobei die Komponenten (10, 11) unmittelbar nach dem Kontakt mit der Vorbehandlungsflüssigkeit mit einem guten Lösungsmittel gespült werden, das die Löslichkeit der gelösten Stoffe ermöglicht, die in Höhe von mindestens 10 % in der Vorbehandlungsflüssigkeit vorhanden sind, sodass nur ein absorbierter Molekularfilm auf der Lötung verbleibt, wobei das gute Lösungsmittel beispielsweise Wasser ist.

9. Verfahren nach einem der vorstehenden Ansprüche, wobei die Komponenten (10, 20) unmittelbar nach dem Kontakt mit der Vorbehandlungsflüssigkeit mit einem schlechten Lösungsmittel gespült werden, das die Löslichkeit von weniger als 0,1 % der gelösten Stoffe ermöglicht, die in der Vorbehandlungsflüssigkeit vorhanden sind, sodass ein dünner Film mit einer nanometrischen Dicke, die zwischen 1 und 100 nm liegt, auf den behandelten Komponenten verbleibt, wobei das schlechte Lösungsmittel beispielsweise Isopropanol ist.

10. Verfahren nach einem der Ansprüche 1 bis 8, wobei die Komponenten (10, 20) unmittelbar nach dem Kontakt mit der Vorbehandlungsflüssigkeit getrocknet werden, danach mit einem schlechten Lösungsmittel von den gelösten Stoffen, die in der Vorbehandlungsflüssigkeit vorhanden sind, gereinigt werden, wobei das schlechte Lösungsmittel beispielsweise Isopropanol ist.

11. Verfahren nach einem der vorstehenden Ansprüche, wobei der Kontakt mit der Vorbehandlungsflüssigkeit durch Eintauchen, und beispielsweise in einem Ultraschallbad erfolgt, wobei die Kontaktzeit mit der Vorbehandlungsflüssigkeit zwischen 1 und 5 Minuten liegt, wobei das Zusammensetzen durch Löten danach weniger als vier Stunden nach der Vorbehandlung im Beisein von Luft oder unter neutralem Gas erfolgt.

12. Verfahren nach Anspruch 3, wobei die Vorbehandlungsflüssigkeit eine Lösung ist, die ein basisches Reinigungsmittel enthält, wobei der pH-Wert der Lösung zwischen 11 und 13 liegt.

13. Verfahren nach Anspruch 1, wobei die Vorbehandlungsflüssigkeit eine Lösung ist, die ein saures Reinigungsmittel enthält, wobei der pH-Wert der Lösung zwischen 1 und 3 liegt.

14. Verfahren nach Anspruch 12 oder 13, wobei das Reinigungsmittel nicht schäumend ist, der Kontakt mit der Vorbehandlungsflüssigkeit durch Eintauchen, und beispielsweise in einem Ultraschallbad erfolgt, wobei die Kontaktzeit mit der Vorbehandlungsflüssigkeit zwischen 1 und 5 Minuten liegt, dem Kontakt mit der Vorbehandlungsflüssigkeit ein Spülen, beispielsweise mit Wasser oder Isopropanol folgt, danach ein Trocknen, wobei das Zusammensetzen durch Löten danach weniger als eine Stunde nach der Vorbehandlung, und vorzugsweise unter Neutralgasatmosphäre erfolgt.

## Claims

1. A solder bump assembly method, allowing to assemble a first component (10) including solder bumps (11) with a second component (20) including connectors (21), the assembly of the components is preceded by a pre-treatment of the components wherein the solder bumps (11) are contacted with a pre-treatment liquid configured to at least partially remove the oxide layer initially present on the solder, and the assembly of the components is carried out after the pre-treatment in the absence of liquid or gas flux, and optionally under an atmosphere of neutral gas such as nitrogen, said method being **characterised in that** the pre-treatment liquid is an aqueous solution containing carboxylic acids or polycarboxylic acids.

2. The method according to claim 1, wherein the contacting with the pre-treatment liquid is configured to leave a thin film on the surface of the treated components (10, 11), with a thickness less than 100 nm, this film having the property of promoting effective soldering without leaving residues after assembly, and allowing the action of the pre-treatment to be prolonged so that the soldering can be done more than one hour after the pre-treatment without reducing the assembly efficiency.

3. The method according to one of the preceding claims, the aqueous solution containing amines or polyamines.

4. The method according to one of the preceding claims, the aqueous solution containing amino acids or poly amino acids.

5. The method according to one of the preceding claims, wherein the pre-treatment liquid is an aqueous solution containing glutamic acid hydrochloride, in a concentration comprised between 10 and 20% by mass.

6. The method according to any one of the preceding claims, wherein the pre-treatment liquid contains a strong acid in an amount sufficient for the pre-treatment liquid to reach a pH of less than 2, this strong acid being for example hydrochloric acid, with a concentration comprised between 0.1% and 1% by mass.

7. The method according to one of the preceding claims, wherein the pre-treatment liquid contains an acid detergent.

8. The method according to one of the preceding claims, wherein the components (10, 11) are rinsed immediately after contact with the pre-treatment liquid with a good solvent allowing the solubilisation of the solutes present in the pre-treatment liquid at an amount of at least 10%, so that only an adsorbed molecular film remains on the solder, said good solvent being for example water.

9. The method according to one of the preceding claims, wherein the components (10, 20) are rinsed immediately after contact with the pre-treatment liquid with a poor solvent allowing not to dissolve more than 0.1% of the solutes present in the pre-treatment liquid, so that a thin film of nanometric thickness comprised between 1 and 100 nm, remains on the treated components, said poor solvent being for example isopropanol.

10. The method according to one of claims 1 to 8, wherein the components (10, 20) are dried immediately after contact with the pre-treatment liquid, then are washed with a poor solvent from the solutes present in the pre-treatment liquid, said poor solvent being for example isopropanol.

11. The method according to one of the preceding claims, wherein the contact with the pre-treatment liquid is made by immersion and for example in an ultrasonic bath, the contact time with the pre-treatment liquid is comprised between 1 and 5 minutes, the assembly by soldering then being carried out less than four hours after the pre-treatment, in the presence of air or under neutral gas.

12. The method according to claim 3, wherein the pre-treatment liquid is a solution containing a basic detergent, the pH of said solution being comprised between 11 and 13.

13. The method according to claim 1, wherein the pre-treatment liquid is a solution containing an acid detergent, the pH of said solution being comprised between 1 and 3.

14. The method according to claims 12 or 13 wherein the detergent is non-foaming, the contact with the pre-treatment liquid can be made by immersion and for example in an ultrasonic bath, the contact time with the pre-treatment liquid is comprised between 1 and 5 minutes, the contact with the pre-treatment liquid is followed by rinsing, carried out for example with water or isopropanol, then by drying, the assembly by soldering then being carried out less one hour after the pre-treatment and preferably under a neutral gas atmosphere.
